# EUROPEAN PATENT APPLICATION

(11) **EP 4 485 634 A1**
(43) Date of publication of application: **01.01.2025**
(21) Application number: 24184316.8
(22) Date of filing: 25.06.2024
(51) Int. Cl.: H01M 50/105, H01M 10/42, H01M 50/209, H01M 50/211, H01M 50/244, H01M 50/519, H01M 50/55

(54) **BATTERY PACK**

(30) Priority: 27.06.2023 KR 20230082614
(71) Applicant: Samsung SDI Co., Ltd., Yongin-si, Gyeonggi-do 17084 (KR)
(72) Inventor: Choi, Jae Hyeok, 16678 Suwon-si, Gyeonggi-do (KR)
(74) Representative: Gulde & Partner

(57) **Abstract**

The present disclosure relates a battery pack that is easy to assemble and can reduce an interference region with an external substrate (S). The present disclosure provides a battery pack including a battery cell (100), a terrace (200) extending from the battery cell (100), a first substrate (300) disposed on the terrace (200) and connected to the battery cell (100), a connector (400) mounted on the first substrate (300), and a second substrate (500) detachably coupled to the connector (400) and extending to the outside of the battery cell (100).

## Description

### BACKGROUND

### 1. Field of the Invention

Aspects of embodiments of the present disclosure relates to a battery pack.

### 2. Discussion of Related Art

Generally, as the demand for portable electronic products such as laptops, camcorders, and mobile phones increases rapidly and the commercialization of robots, electric cars, and the like begins in earnest, research on high-performance secondary batteries capable of repeated charging and discharging is actively underway. In particular, lithium secondary batteries are widely used as an energy source of various electronic products due to having high energy density and operating voltage and having excellent preservation and state-of-health (SOH) characteristics.

Among the lithium secondary batteries, a battery pack using a pouch type cell is assembled to an external substrate through a connector mounted on a flexible printed circuit board (FPCB) after the FPCB is connected to a printed circuit board (PCB). However, when assembly positions of the external substrate and the FPCB are relatively far apart, material costs increase due to an increase in the length of the FPCB, and a component mounting region of the external substrate loses as much area as the increased length of the FPCB.

The above-described information disclosed in the technology that forms the background of the present disclosure is only intended to improve understanding of the background of the present disclosure, and thus may include information that does not constitute the related art.

### SUMMARY OF THE INVENTION

An aspect of the present disclosure is directed to a battery pack that is easy to assemble and can reduce an interference region with an external substrate.

These and other aspects and features of the present disclosure will be described in or will be apparent from the following description of some embodiments of the present disclosure.

According to an aspect of the present disclosure, a battery pack includes a battery cell; a terrace (e.g. a thin, outwardly directed extension of the battery cell, such as formed by an outer material that surrounds the electrode arrangement of the battery cell) extending from the battery cell; a first substrate disposed on the terrace and connected to the battery cell; a connector mounted on the first substrate; and a second substrate detachably coupled to the connector and extending to the outside of the battery cell.

The first substrate may include: a first surface disposed to face the terrace; and a second surface disposed at an opposite side of the first surface, and the connector may be mounted on the second surface. An electronic device may be mounted on the first surface, the second surface, or on both the first surface and the second surface.

The connector may be disposed in a central portion of the first substrate.

The battery pack may further include a pair of connection tabs configured to extend from the terrace and to connect the battery cell and the first substrate, and the connector may be disposed between the pair of connection tabs.

The second substrate may have flexibility.

The second substrate may include: a first region disposed to face the battery cell; and a second region configured to extend from the first region and to protrude to the outside of the battery cell, and a length of the first region may be greater than a length of the second region.

The battery pack may further include a support member configured to prevent deformation of the first substrate.

The support member may include: a first support member disposed between the terrace and the first substrate; and a second support member configured to extend from the first support member and to come in contact with a floor surface on which the battery cell is seated.

The first support member and/or the second support member may be elastically deformable.

The support member may include: a first support member disposed between the terrace and the first substrate; and a second support member spaced apart from the first support member and disposed between the terrace and a floor surface on which the battery cell is seated.

The support member may include: a first support member fixed to the battery cell and configured to support the first substrate relative to the terrace; and a second support member spaced apart from the first support member and disposed between the terrace and a floor surface on which the battery cell is seated.

The first support member may include: a support case; an insertion portion disposed in the support case and into which the first substrate is inserted; and an opening formed to pass through the support case and configured to expose the connector to the outside.

The first support member may further include a separation prevention member configured to protrude from the support case toward the insertion portion and to be elastically deformable.

The first support member may further include a reinforcing rib coupled to the support case and configured to reinforce the rigidity of the support case.

The battery pack may further include: a protective film disposed to surround the first substrate and having a slit through which the connector is exposed to the outside; and a marking line disposed to be spaced apart from the connector on the first substrate and selectively exposed to the outside according to an area of the slit.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The drawings attached to this specification illustrate some embodiments of the present disclosure, and further describe aspects and features of the present disclosure together with the detailed description of the present disclosure. However, the present disclosure should not be construed as being limited to the drawings:
FIG. 1 is a view schematically illustrating an installation state of a battery pack according to a first embodiment of the present disclosure.
FIG. 2 is a perspective view schematically illustrating a configuration of the battery pack according to the first embodiment of the present disclosure.
FIG. 3 is an exploded perspective view schematically illustrating the configuration of the battery pack according to the first embodiment of the present disclosure.
FIG. 4 is an enlarged view schematically illustrating the configuration of the battery pack according to the first embodiment of the present disclosure.
FIG. 5 is a cross-sectional view schematically illustrating the configuration of the battery pack according to the first embodiment of the present disclosure.
FIG. 6 is an enlarged view schematically illustrating the configurations of a flame retardant film and a marking line according to the first embodiment of the present disclosure.
FIG. 7 is a perspective view schematically illustrating a configuration of a battery pack according to a second embodiment of the present disclosure.
FIG. 8 is a front view schematically illustrating the configuration of the battery pack according to the second embodiment of the present disclosure.
FIG. 9 is a perspective view schematically illustrating a configuration of a battery pack according to a third embodiment of the present disclosure.
FIG. 10 is a perspective view illustrating the configuration of the battery pack according to the third embodiment of the present disclosure from a different perspective from FIG. 9.
FIG. 11 is a cross-sectional view schematically illustrating the configuration of the battery pack according to the third embodiment of the present disclosure.
FIG. 12 is a perspective view schematically illustrating a configuration of a battery pack according to a fourth embodiment of the present disclosure.
FIG. 13 is a cross-sectional view schematically illustrating the configuration of the battery pack according to the fourth embodiment of the present disclosure.
FIG. 14 is a perspective view schematically illustrating a configuration of a battery pack according to a fifth embodiment of the present disclosure.
FIG. 15 is a cross-sectional view schematically illustrating the configuration of the battery pack according to the fifth embodiment of the present disclosure.
FIG. 16 is a perspective view schematically illustrating a configuration of a first support member according to the fifth embodiment of the present disclosure.
FIG. 17 is a perspective view illustrating the configuration of the first support member according to the fifth embodiment of the present disclosure from a different perspective from FIG. 16.

### DETAILED DESCRIPTION OF EXEMPLARY EMBODIMENTS

Herein, some embodiments of the present disclosure will be described, in further detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term.

The embodiments described in this specification and the configurations shown in the drawings are provided as some example embodiments of the present disclosure and do not represent all of the technical ideas, aspects, and features of the present disclosure. Accordingly, it is to be understood that there may be various equivalents and modifications that may replace or modify the embodiments described herein at the time of filing this application.

It is to be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same or like elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B, and C," "at least one of A, B, or C," "at least one selected from a group of A, B, and C," or "at least one selected from among A, B, and C" are used to designate a list of elements A, B, and C, the phrase may refer to any and all suitable combinations or a subset of A, B, and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It is to be understood that, although the terms "first," "second," "third," etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (e.g., rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It is to be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of " 1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being arranged (or located or positioned) on the "above (or below)" or "on (or under)" a component, it may mean that the arbitrary element is placed in contact with the upper (or lower) surface of the component and may also mean that another component may be interposed between the component and any arbitrary element arranged (or located or positioned) on (or under) the component.

In addition, it is to be understood that when an element is referred to as being "coupled," "linked," or "connected" to another element, the elements may be directly "coupled," "linked," or "connected" to each other, or one or more intervening elements may be present therebetween, through which the element may be "coupled," "linked," or "connected" to another element. In addition, when a part is referred to as being "electrically coupled" to another part, the part may be directly electrically connected to another part or one or more intervening parts may be present therebetween such that the part and the another part are indirectly electrically connected to each other.

Throughout the specification, when "A and/or B" is stated, it means A, B, or A and B, unless otherwise stated. That is, "and/or" includes any or all combinations of a plurality of items enumerated. When "C to D" is stated, it means C or more and D or less, unless otherwise specified.

The terms used in the present specification are for describing embodiments of the present disclosure and are not intended to limit the present disclosure.

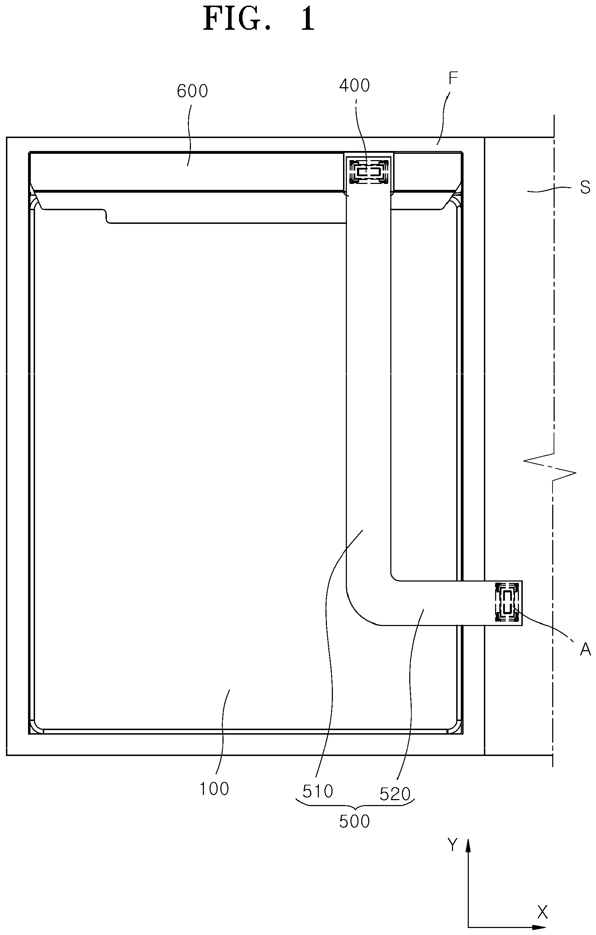

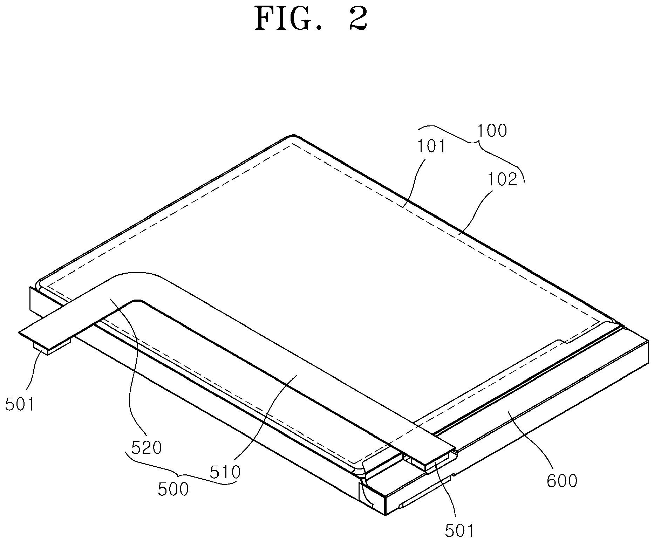

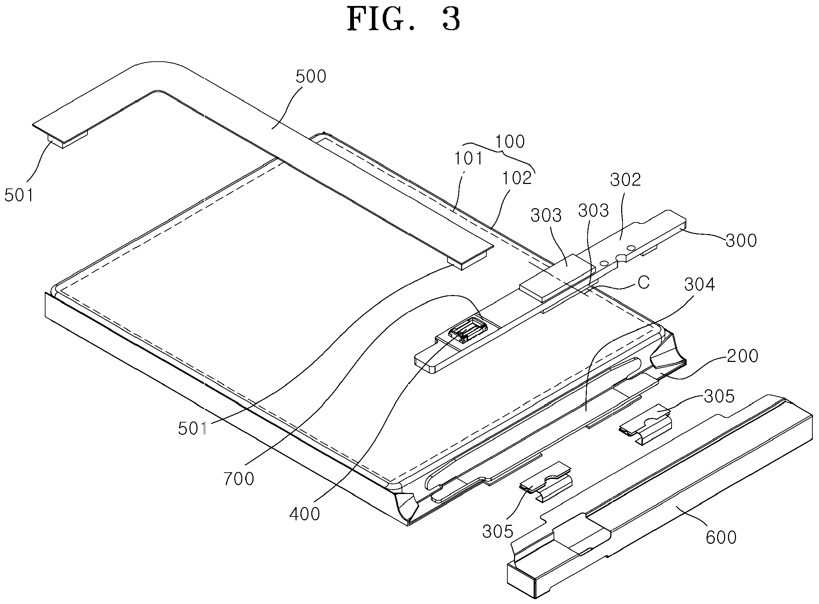

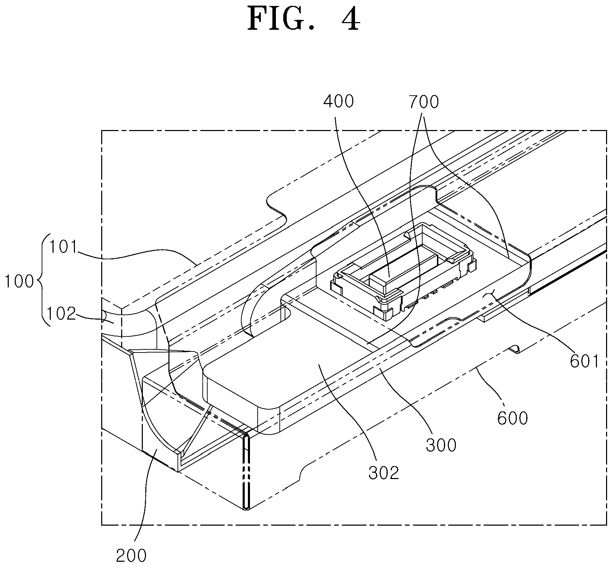

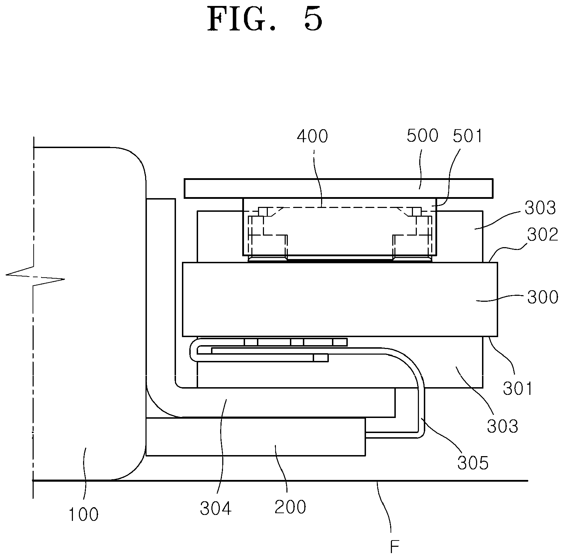

FIG. 1 is a view schematically illustrating an installation state of a battery pack according to a first embodiment of the present disclosure, FIG. 2 is a perspective view schematically illustrating a configuration of the battery pack according to the first embodiment of the present disclosure, FIG. 3 is an exploded perspective view schematically illustrating the configuration of the battery pack according to the first embodiment of the present disclosure, FIG. 4 is an enlarged view schematically illustrating the configuration of the battery pack according to the first embodiment of the present disclosure, and FIG. 5 is a cross-sectional view schematically illustrating the configuration of the battery pack according to the first embodiment of the present disclosure.

Referring to FIGS. 1 to 5, a battery pack according to the present embodiment includes a battery cell 100, a terrace 200, a first substrate 300, a connector 400, and a second substrate 500.

The battery cell 100 is a unit structure that stores and supplies power and may be a lithium secondary battery capable of charging and discharging a predetermined amount of power. The battery cell 100 according to the present embodiment may be a pouch type battery cell including an electrode assembly 101 and an exterior material 102 surrounding the electrode assembly 101.

Although not illustrated in the drawings, the electrode assembly 101 may be formed as a winding type in which first and second electrode plates and a separator interposed between the first and second electrode plates are wound in the form of a roll or may be formed as a stacking type in which the first and second electrode plates and the separator are stacked on top of one another.

The battery cell 100 may have a lower surface seated on a floor surface F of a housing of various electronic devices such as a laptop, a camcorder, or a mobile phone. In the housing, the battery cell 100 may be disposed adjacent to an external substrate S for controlling the power supply, operation, or the like of the electronic device.

The terrace 200 extends from the battery cell 100 and supports the first substrate 300, which will be described below, relative to the battery cell 100. The terrace 200 according to the present embodiment may be formed to have the shape of a plate that horizontally extends from an end surface of the battery cell 100 in a direction parallel to a length direction of the battery cell 100 (the Y-axis direction based on FIG. 1). The terrace 200 may be integrally formed with the battery cell 100 or may be produced separately from the battery cell 100 and then coupled to the battery cell 100. A lower surface of the terrace 200 may be disposed to be spaced a predetermined distance apart from the floor surface F.

The first substrate 300 is disposed on the terrace 200 and is electrically connected to the battery cell 100. The first substrate 300 according to the present embodiment may be a printed circuit board (PCB) in the form of a flat plate that is configured to include opposing first and second surfaces 301 and 302. The first substrate 300 may be a double-sided mounting substrate in which components can be mounted on both the first surface 301 and the second surface 302. The first substrate 300 may have a length direction disposed parallel to a width direction of the battery cell 100 (the X-axis direction based on FIG. 1).

The first surface 301 of the first substrate 300 may be disposed to face downward and face an upper surface of the terrace 200. The second surface 302 of the first substrate 300 may be disposed to face upward and face an upper space of the battery cell 100. Various types of electronic devices 303 for forming a path for the charge/discharge current of the battery cell 100 or performing a protective operation for preventing overheating or explosions that occur due to overheating, overcharging, overdischarging or the like of the battery cell 100 may be mounted on the first surface 301 of the first substrate 300. However, the electronic devices 303 are not limited thereto and may also be mounted on the second surface 302, or on both the first surface 301 and the second surface 302.

A fixing tape 304 for fixing the first substrate 300 relative to the terrace 200 may be installed between the first substrate 300 and the terrace 200. The fixing tape 304 according to the present embodiment may be a tape in the form of a sheet having an adhesive material applied on a surface thereof. The fixing tape 304 may have a shape that is bent in a substantially L-shape, and an inner surface of the fixing tape 304 may be seated on the end surface of the battery cell 100 and the upper surface of the terrace 200. As the electronic device 303 mounted on the first surface 301 is adhered to an outer surface of the fixing tape 304, the first substrate 300 may be stably fixed on the terrace 200.

The first substrate 300 may be electrically connected to the battery cell 100 by a connection tab 305 extending from the terrace 200. The connection tab 305 may be formed of an electrically conductive material such as nickel and aluminum. The connection tab 305 may be formed as a pair of connection tabs 305. One end of one of the pair of connection tabs 305 and one end of the other of the pair of connection tabs 305 may be respectively connected to the first and second electrode plates of the battery cell 100 that have different polarities. The other end of each of the pair of connection tabs 305 may be connected to the first surface 301 of the first substrate 300. The other ends of the pair of connection tabs 305 may be disposed to be spaced apart from each other on the first substrate 300 in the width direction of the battery cell 100. The pair of connection tabs 305 may be disposed to be symmetrical about a center line C of the first substrate 300.

The connector 400 is mounted on the first substrate 300 and serves as a component that provides an electrical connection between the first substrate 300 and the second substrate 500. The connector 400 according to the present embodiment may be any of various types of connection means that use a male-female coupling method and are electrically connected to the first substrate 300. The connector 400 may be mounted on the second surface 302 of the first substrate 300. Accordingly, since the connector 400 may be exposed at the upper space of the battery cell 100, fastening the connector 400 to the second substrate 500, which will be described below, can be more easily performed. The connector 400 may be disposed at one end of the first substrate 300 in a length direction thereof.

The second substrate 500 has one side detachably coupled to the connector 400 and extending to the outside of the battery cell 100. Since the other side of the second substrate 500 is connected to the external substrate S, the second substrate 500 can electrically connect the battery cell 100 and the external substrate S.

The second substrate 500 according to the present embodiment may be formed to have flexibility. For example, the second substrate 500 may be a flexible printed circuit board (FPCB) that is bendable by laminating a flexible copper clad laminate (FCCL) that is made of a flexible insulating layer, such as a polyimide film, and a copper foil.

A pair of intermediate connectors 501 may be respectively formed at both ends of the second substrate 500. The pair of intermediate connectors 501 may be detachably coupled to the connector 400 mounted on the first substrate 300 and an external connector A mounted on the external substrate S, respectively. Accordingly, since a worker may replace only the second substrate 500 with a second substrate 500 having a different length while the battery cell 100, the first substrate 300, and the like are kept the same, it is possible to flexibly respond to positional changes between the battery cell 100 and the external substrate S and reduce costs for producing a battery pack.

The second substrate 500 may include a first region 510 and a second region 520.

The first region 510 may refer to a region disposed to face the battery cell 100 among the entire length of the second substrate 500. The first region 510 according to the present embodiment may have an end disposed to face the connector 400 and extending in the length direction of the battery cell 100. One intermediate connector 501 may be disposed at the end of the first region 510.

The second region 520 is a region excluding the first region 510 among the entire length of the second substrate 500 and may refer to a region that extends from the first region 510 and protrudes to the outside of the battery cell 100. The second region 520 according to the present embodiment may extend from the first region 510 in the width direction of the battery cell 100. An end of the second region 520 may protrude to the outside of the battery cell 100 and may be disposed to face the external connector A on the external substrate S. The other intermediate connector 501 may be disposed at the end of the second region 520.

A length of the first region 510 may be formed larger than a length of the second region 520. Accordingly, by relatively reducing the size of a region in which the second substrate 500 interferes with the external substrate S, a wider space can be secured for mounting components on the external substrate S.

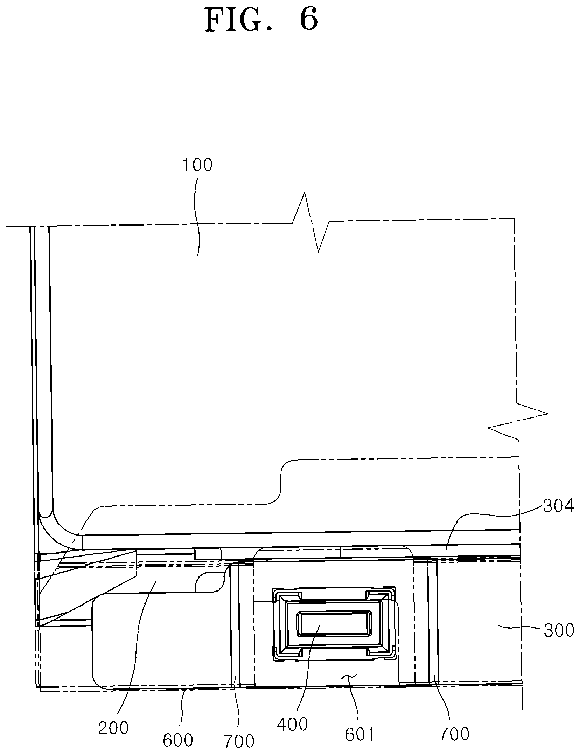

FIG. 6 is an enlarged view schematically illustrating the configurations of a flame retardant film and a marking line according to the first embodiment of the present disclosure.

Referring to FIGS. 1 to 6, the battery pack according to the present embodiment may further include a protective film 600 and a marking line 700.

The protective film 600 may be formed to have the shape of a film with a small thickness and may be disposed to surround the first substrate 300 on the outer side of the battery cell 100. The protective film 600 may perform a function of protecting the first substrate 300 from external foreign matter and the like. Also, the protective film 600 may be formed of a flame retardant material such as polyethylene (PET) and may perform a function of preventing the first substrate 300 from being directly exposed to flames in the event of a fire. The protective film 600 may have an edge fixed to a surface of the exterior material 102 of the battery cell 100 by an adhesive or the like.

A slit 601 for exposing the connector 400 mounted on the first substrate 300 to an external space may be formed in the protective film 600. The slit 601 according to the present embodiment may be formed to have the shape of a hole that is formed to pass through the protective film 600. An area of the slit 601 may be formed larger than an area of the connector 400. When the protective film 600 is installed to surround the first substrate 300, the connector 400 may be exposed to the upper space of the battery cell 100 through the slit 601. Accordingly, the slit 601 may prevent a connection path between the connector 400 and the second substrate 500 from being blocked due to the protective film 600. The protective film 600 may be disposed to surround the lower surface of the terrace 200.

The marking line 700 is disposed on the first substrate 300 and visually provides information on the area of the slit 601. More specifically, the marking line 700 may serve as a component that visually provides information to the worker as to whether the area of the slit 601 is formed larger or smaller than a predetermined area that does not excessively degrade the flame retardant performance of the protective film 600. Accordingly, the marking line 700 may reduce the time taken for a process of installing the protective film 600.

The marking line 700 according to the present embodiment may be formed to have the shape of a line that is marked on the second surface 302 of the first substrate 300. The marking line 700 may be formed to have a color that can distinguish the marking line 700 from the first substrate 300. The marking line 700 may be formed as a pair of marking lines 700. The pair of marking lines 700 may have a length direction disposed parallel to the length direction of the battery cell 100. The pair of marking lines 700 may be disposed to be spaced apart from each other in a length direction of the first substrate 300. The pair of marking lines 700 may be respectively disposed at both sides of the connector 400 with the connector 400 disposed therebetween. Each marking line 700 may be spaced 1.5 mm or less from the connector 400. When the area of the slit 601 is within a range of the predetermined area, an interval between the pair of marking lines 700 may be larger than a width of the slit 601 that is parallel to the length direction of the first substrate 300, and the marking lines 700 may be covered by the protective film 600 and may not be exposed to the outside. Meanwhile, when the area of the slit 601 exceeds the range of the predetermined area, the marking lines 700 may be exposed to the external space through the slit 601, and the worker may recognize that the area of the slit 601 has deviated from the range of the predetermined area through the exposure of the marking lines 700 to the outside through the slit 601.

Hereinafter, a battery pack according to a second embodiment of the present disclosure will be described.

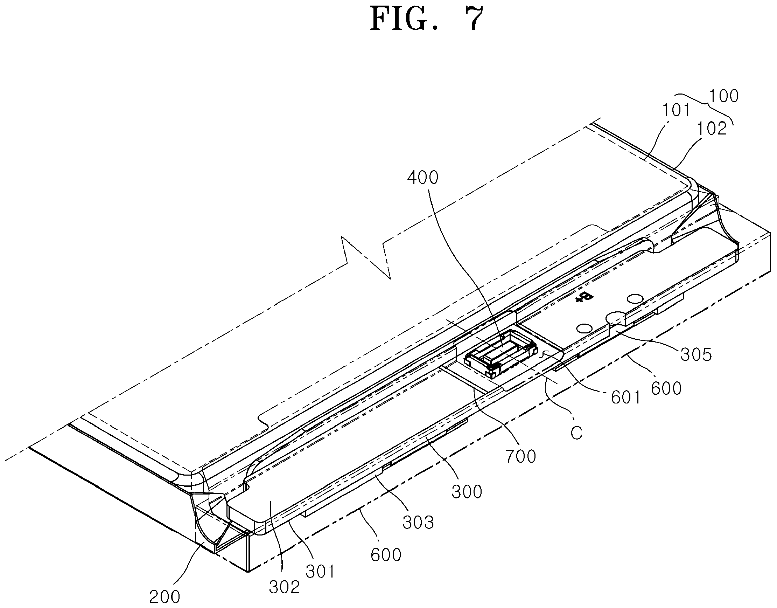

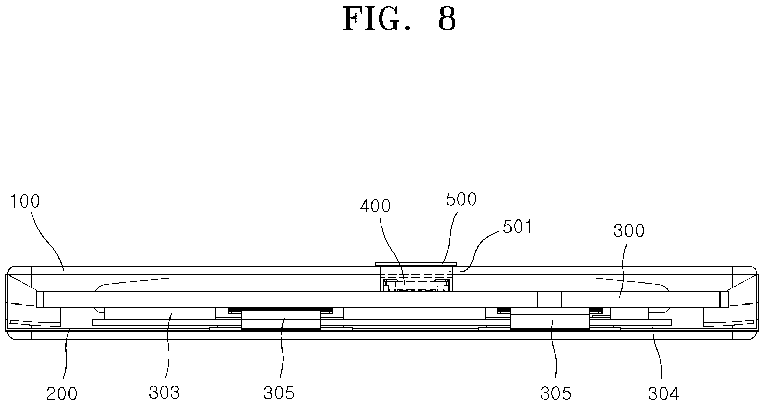

FIG. 7 is a perspective view schematically illustrating a configuration of a battery pack according to a second embodiment of the present disclosure, and FIG. 8 is a front view schematically illustrating the configuration of the battery pack according to the second embodiment of the present disclosure.

Referring to FIGS. 7 and 8, the battery pack according to the second embodiment of the present disclosure may be configured to be the same as the battery pack according to the first embodiment of the present disclosure except for the arrangement structure of the connector 400.

Accordingly, in describing the configuration of the battery pack according to the second embodiment of the present disclosure, only the arrangement structure of the connector 400 that is different from the battery pack according to the first embodiment of the present disclosure will be described.

The description of the battery pack according to the first embodiment of the present disclosure may be applied as is to the remaining configurations of the battery pack according to the second embodiment of the present disclosure.

The connector 400 according to the present embodiment may be disposed in a central portion of the first substrate 300. More specifically, the connector 400 may be disposed between the pair of connection tabs 305 spaced apart from each other in the length direction of the first substrate 300, that is, disposed on the center line C of the first substrate 300. In this case, the connector 400 may induce a certain amount of pressing force, which is generated in a process of fastening the second substrate 500 to the connector 400, to be distributed to the pair of connection tabs 305 that support the first substrate 300 on both sides of the connector 400. Accordingly, as compared to the case where the connector 400 is disposed at an end of the first substrate 300, the battery pack according to the present embodiment may relatively reduce the amount of deformation of the first substrate 300 that is caused by the pressing force generated in the process of fastening the second substrate 500 to the connector 400.

Hereinafter, a battery pack according to a third embodiment of the present disclosure will be described.

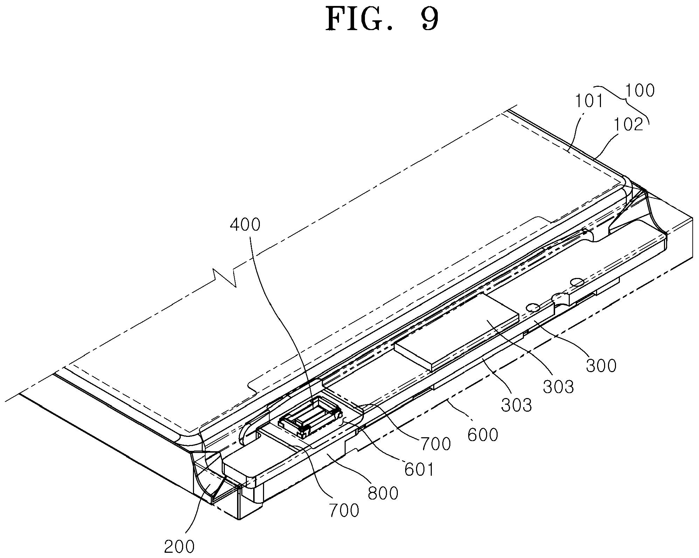

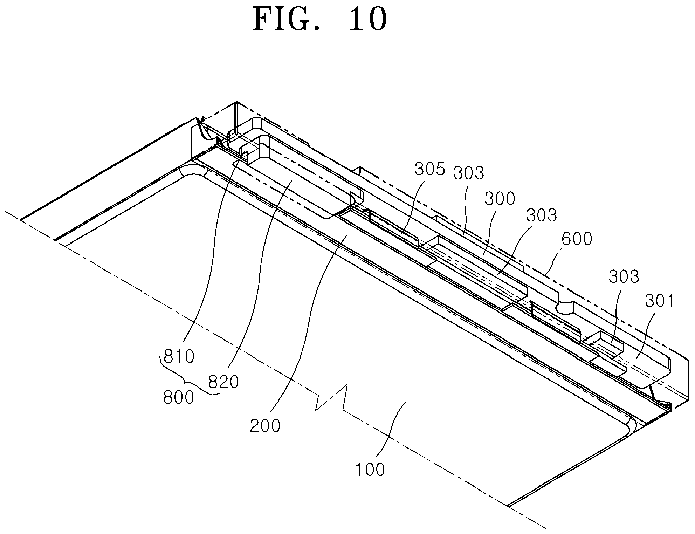

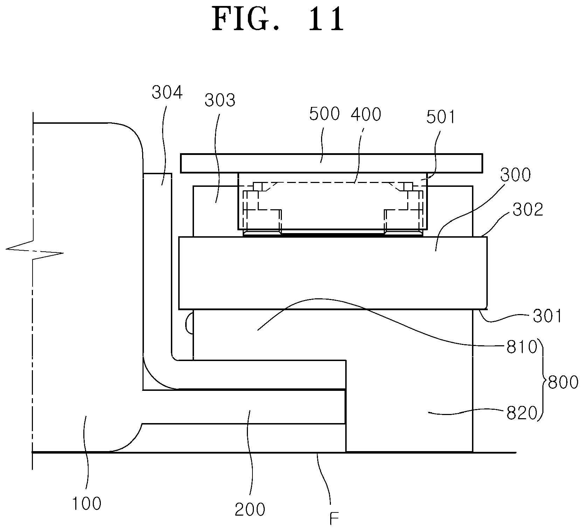

FIG. 9 is a perspective view schematically illustrating a configuration of a battery pack according to a third embodiment of the present disclosure, FIG. 10 is a perspective view illustrating the configuration of the battery pack according to the third embodiment of the present disclosure from a different perspective from FIG. 9, and FIG. 11 is a cross-sectional view schematically illustrating the configuration of the battery pack according to the third embodiment of the present disclosure.

Referring to FIGS. 9 to 11, the battery pack according to the third embodiment of the present disclosure may be configured to be the same as the battery pack according to the first embodiment or second embodiment of the present disclosure except for further including a support member 800.

Accordingly, in describing the configuration of the battery pack according to the third embodiment of the present disclosure, only the support member 800 that has not been described above in describing the battery pack according to the first embodiment or second embodiment of the present disclosure will be described. The description of the battery pack according to the first embodiment or second embodiment of the present disclosure may be applied as is to the remaining configurations of the battery pack according to the third embodiment of the present disclosure.

Meanwhile, although an example in which the support member 800 is applied to the battery pack according to the first embodiment of the present disclosure is illustrated in FIGS. 9 to 11 for convenience of description, the support member 800 is not limited thereto and may also be applied to the battery pack according to the second embodiment of the present disclosure.

The support member 800 prevents the first substrate 300 from being deformed and sagging due to the pressing force generated in the process of fastening the second substrate 500 to the connector 400. Accordingly, the support member 800 may prevent damage to components due to deformation and sagging of the first substrate 300 and prevent the second substrate 500 from not being fastened to the connector 400.

The support member 800 according to the present embodiment may include a first support member 810 and a second support member 820.

The first support member 810 is disposed between the terrace 200 and the first substrate 300. The first support member 810 may be formed to have a flat plate shape. The first support member 810 may be inserted into an empty space formed between the terrace 200, more specifically, the fixing tape 304 seated on the upper surface of the terrace 200, and the first substrate 300. An upper surface of the first support member 810 may come in contact with a lower surface of the first substrate 300, that is, the first surface 301. One portion of a lower surface of the first support member 810 may come in contact with an upper surface of the fixing tape 304, and the remaining portion of the lower surface of the first support member 810 may protrude to the outside of the terrace 200.

The first support member 810 may be disposed at a position facing the connector 400 with the first substrate 300 disposed therebetween. In this case, an area of the first support member 810 may be formed larger than an area of the connector 400. Accordingly, the first support member 810 may evenly absorb the pressing force generated throughout the area of the connector 400.

The second support member 820 extends from the first support member 810 and comes in contact with the floor surface F of the housing of the electronic device on which the battery cell 100 is seated. That is, the second support member 820 may serve as a component that distributes the pressing force transmitted to the first support member 810 through the first substrate 300 to the floor surface F. Accordingly, the second support member 820 may prevent the first substrate 300 from sagging due to the deformation of the terrace 200 that occurs as the pressing force transmitted to the first support member 810 through the first substrate 300 is concentrated on the terrace 200.

The second support member 820 according to the present embodiment may be formed to have the shape of a column that vertically extends toward the floor surface F from an end of the first support member 810 that protrudes to the outside of the terrace 200. A lower surface of the second support member 820 may directly come in contact with the floor surface F of the housing of the electronic device on which the battery cell 100 is seated.

The first support member 810 and the second support member 820 may be formed of a flexible material such as rubber and silicone to enable elastic deformation. Accordingly, the first support member 810 and the second support member 820 may offset the pressing force generated in the process of fastening the second substrate 500 to the connector 400 by their elastic restoring force.

Hereinafter, a battery pack according to a fourth embodiment of the present disclosure will be described.

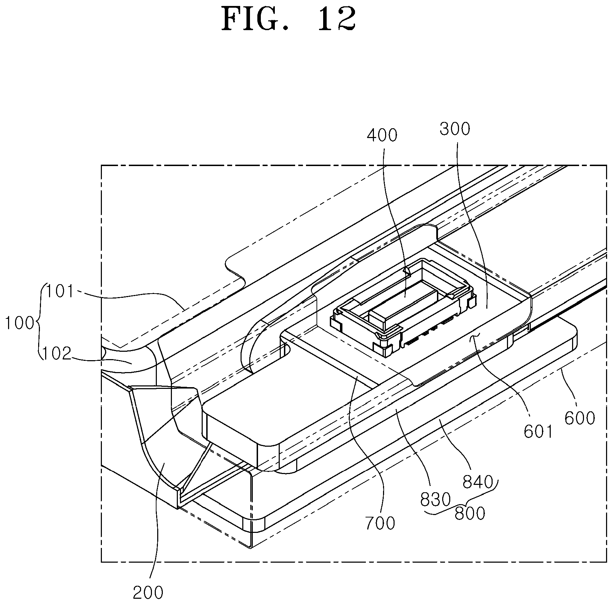

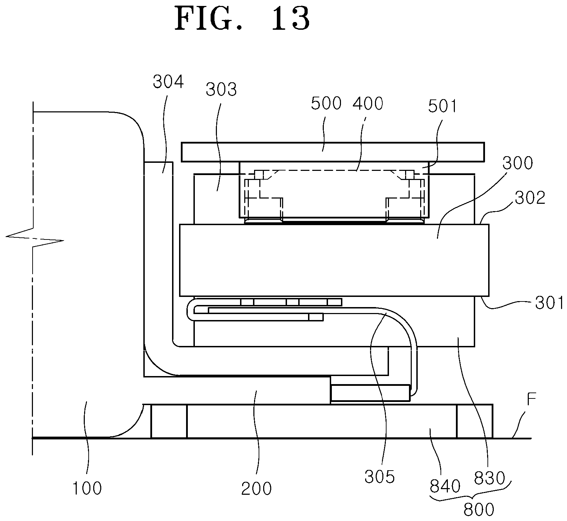

FIG. 12 is a perspective view schematically illustrating a configuration of a battery pack according to a fourth embodiment of the present disclosure, and FIG. 13 is a cross-sectional view schematically illustrating the configuration of the battery pack according to the fourth embodiment of the present disclosure.

Referring to FIGS. 12 and 13, the battery pack according to the fourth embodiment of the present disclosure may be configured to be the same as the battery pack according to the third embodiment of the present disclosure except for a specific configuration of the support member 800.

Accordingly, in describing the configuration of the battery pack according to the fourth embodiment of the present disclosure, only the specific configuration of the support member 800 that is different from the battery pack according to the third embodiment of the present disclosure will be described. The description of the battery pack according to the third embodiment of the present disclosure may be applied as is to the remaining configurations of the battery pack according to the fourth embodiment of the present disclosure.

The support member 800 according to the present embodiment may include a first support member 830 and a second support member 840.

The first support member 830 is disposed between the terrace 200 and the first substrate 300. The first support member 830 may be formed to have a flat plate shape. The first support member 830 may be inserted into an empty space formed between the terrace 200, more specifically, the fixing tape 304 seated on the upper surface of the terrace 200, and the first substrate 300. An upper surface of the first support member 830 may come in contact with the lower surface of the first substrate 300, that is, the first surface 301. One portion of a lower surface of the first support member 830 may come in contact with the upper surface of the fixing tape 304.

The first support member 830 may be disposed at a position facing the connector 400 with the first substrate 300 disposed therebetween. In this case, an area of the first support member 830 may be formed larger than an area of the connector 400. Accordingly, the first support member 830 may evenly absorb the pressing force generated throughout the area of the connector 400.

The second support member 840 is spaced apart from the first support member 830 and is disposed between the terrace 200 and the floor surface F on which the battery cell 100 is seated. That is, the second support member 840 may serve as a component that directly supports the terrace 200 relative to the floor surface F. Accordingly, the second support member 840 may prevent the first substrate 300 from sagging due to the deformation of the terrace 200.

The second support member 840 according to the present embodiment may be formed to have a flat plate shape. The second support member 840 may be inserted into an empty space formed between the lower surface of the terrace 200 and the floor surface F. An upper surface of the second support member 840 may come in contact with the lower surface of the terrace 200 or come in contact with the protective film 600 when the protective film 600 is disposed to surround the lower surface of the terrace 200. A lower surface of the second support member 840 may come in contact with the floor surface F.

The first support member 830 and the second support member 840 may be formed of a flexible material such as rubber and silicone to enable elastic deformation. Accordingly, the first support member 830 and the second support member 840 may offset the pressing force generated in the process of fastening the second substrate 500 to the connector 400 by their elastic restoring force.

Hereinafter, a battery pack according to a fifth embodiment of the present disclosure will be described.

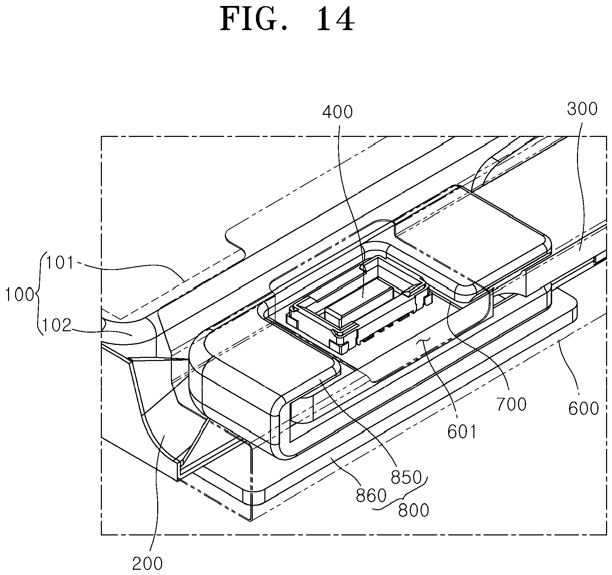

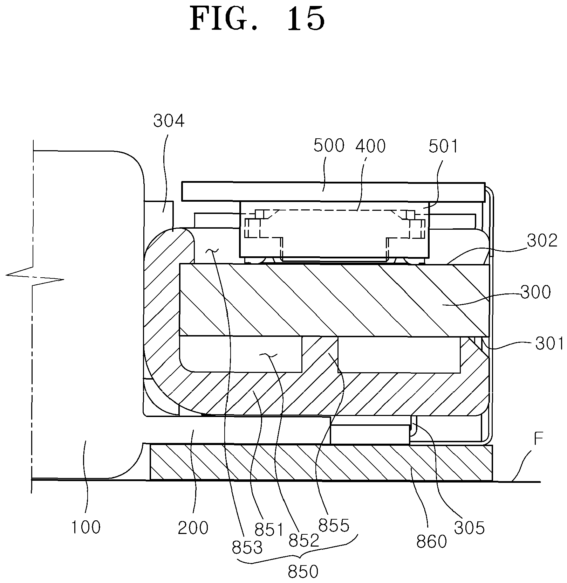

FIG. 14 is a perspective view schematically illustrating a configuration of a battery pack according to a fifth embodiment of the present disclosure, and FIG. 15 is a cross-sectional view schematically illustrating the configuration of the battery pack according to the fifth embodiment of the present disclosure.

The battery pack according to the fifth embodiment of the present disclosure may be configured to be the same as the battery pack according to the third embodiment of the present disclosure except for a specific configuration of the support member 800.

Accordingly, in describing the configuration of the battery pack according to the fifth embodiment of the present disclosure, only the specific configuration of the support member 800 that is different from the battery pack according to the third embodiment of the present disclosure will be described. The description of the battery pack according to the third embodiment of the present disclosure may be applied as is to the remaining configurations of the battery pack according to the fifth embodiment of the present disclosure.

The support member 800 according to the present embodiment may include a first support member 850 and a second support member 860.

The first support member 850 is fixed to the battery cell 100 and supports the first substrate 300 relative to the terrace 200. The first support member 850 may be formed of a material having higher rigidity than the first substrate 300. Accordingly, the first support member 850 may prevent the first substrate 300 from being deformed by absorbing the pressing force generated in the process of fastening the connector 400 and the second substrate 500 due to its rigidity.

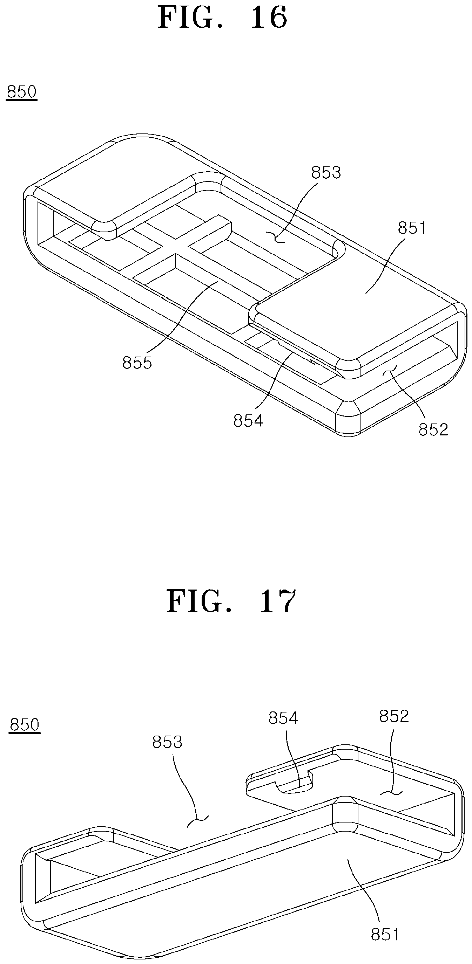

FIG. 16 is a perspective view schematically illustrating a configuration of a first support member according to the fifth embodiment of the present disclosure, and FIG. 17 is a perspective view illustrating the configuration of the first support member according to the fifth embodiment of the present disclosure from a different perspective from FIG. 16.

Referring to FIGS. 15 to 17, the first support member 850 according to the present embodiment may include a support case 851, an insertion portion 852, and an opening 853.

The support case 851 forms the overall exterior of the first support member 850 and is fixed to the battery cell 100. The support case 851 according to the present embodiment may be formed to be substantially box-shaped and may be disposed on the terrace 200. One surface of the support case 851 may come in contact with the end surface of the battery cell 100 from which the terrace 200 extends, and the other surface of the support case 851 may come in contact with the upper surface of the terrace 200. The support case 851 may be fixed to at least one of the end surface of the battery cell 100 and the upper surface of the terrace 200 by various types of coupling methods such as welding and adhesion.

The insertion portion 852 is disposed in the support case 851, and the first substrate 300 is inserted into the insertion portion 852. The insertion portion 852 according to the present embodiment may be formed to have the shape of a groove that is formed to be concavely recessed from a peripheral surface of the support case 851 in a direction parallel to the first substrate 300. A height of the insertion portion 852 may be formed larger than a distance between the first surface 301 and the second surface 302 of the first substrate 300. One portion of a peripheral surface of the insertion portion 852 may communicate with an external space of the support case 851, and the remaining portion thereof may be disposed to face an inner surface of the support case 851.

The first substrate 300 may be inserted into the insertion portion 852 through the portion of the peripheral surface of the insertion portion 852 that communicates with the external space of the support case 851. As the first substrate 300 is inserted into the insertion portion 852, the support case 851 may be disposed to surround the first substrate 300. For example, as illustrated in FIG. 15, the support case 851 may be disposed to surround an end of the first substrate 300. In this case, the support case 851 may block the end of the first substrate 300 from being directly exposed to the outside, thereby further simplifying the shape of the protective film 600 at the end of the first substrate 300.

The opening 853 is formed to pass through the support case 851 and exposes the connector 400 to the outside. The opening 853 according to the present embodiment may be formed to have the shape of a hole that vertically passes through an upper surface of the support case 851 toward the second surface 302 of the first substrate 300. The opening 853 may vertically communicate with the slit 601. Accordingly, the connector 400 may be exposed to the upper space of the battery cell 100 sequentially through the opening 853 and the slit 601. A width of the opening 853 that is parallel to the length direction of the first substrate 300 may be larger than the interval between the pair of marking lines 700. Accordingly, the opening 853 may enable the pair of marking lines 700 to be identified from the outside.

The pressing force generated in the process of fastening the second substrate 500 to the connector 400 exposed to the outside through the opening 853 may be transmitted to the support case 851 through the first surface 301 of the first substrate 300. The support case 851 may prevent the first substrate 300 from being deformed by distributing the pressing force received by the first substrate 300 due to its rigidity.

The first support member 850 according to the present embodiment may further include a separation prevention member 854.

The separation prevention member 854 serves as a component that prevents the first substrate 300 from being separated from the insertion portion 852. The separation prevention member 854 according to the present embodiment may protrude from the inner surface of the support case 851 toward the insertion portion 852 and may be disposed to block an insertion path of the first substrate 300 into the insertion portion 852. The separation prevention member 854 may be elastically deformable. Accordingly, when the first substrate 300 is inserted into the insertion portion 852, the separation prevention member 854 may be elastically deformed due to coming in contact with the first substrate 300 and may open the insertion path of the first substrate 300. The separation prevention member 854 may be formed to have the shape of a hook in order to be caught on and coupled to an outer surface of the first substrate 300 when the first substrate 300 is completely inserted into the insertion portion 852. Accordingly, when the first substrate 300 is completely inserted into the insertion portion 852, the separation prevention member 854 may block the insertion path of the first substrate 300 to prevent the first substrate 300 from being separated from the insertion portion 852. Although an example in which a single separation prevention member 854 is formed is illustrated in FIG. 17, the number of separation prevention members 854 is not limited thereto, and a plurality of separation prevention members 854 may also be formed.

The first support member 850 according to the present embodiment may further include a reinforcing rib 855.

The reinforcing rib 855 is coupled to the support case 851 and reinforces the rigidity of the support case 851. The reinforcing rib 855 according to the present embodiment may be formed to have the shape of a bar that protrudes from a floor surface of the support case 851 toward the insertion portion 852. The reinforcing rib 855 may be formed as a plurality of reinforcing ribs 855. The reinforcing rib 855 may be disposed to form a lattice shape in the insertion portion 852. The reinforcing rib 855 may be formed of the same material as the support case 851 or formed of a material having higher rigidity than the support case 851. When the first substrate 300 is inserted into the insertion portion 852, the reinforcing rib 855 may directly come in contact with the first surface 301 of the first substrate 300.

The second support member 860 is spaced apart from the first support member 850 and is disposed between the terrace 200 and the floor surface F on which the battery cell 100 is seated. That is, the second support member 860 may serve as a component that directly supports the terrace 200 relative to the floor surface F. Accordingly, the second support member 860 may prevent the first substrate 300 from sagging due to the deformation of the terrace 200.

The second support member 860 according to the present embodiment may be formed to have a flat plate shape. The second support member 860 may be inserted into an empty space formed between the lower surface of the terrace 200 and the floor surface F. An upper surface of the second support member 860 may come in contact with the lower surface of the terrace 200 or come in contact with the protective film 600 when the protective film 600 is disposed to surround the lower surface of the terrace 200. A lower surface of the second support member 860 may come in contact with the floor surface F.

The second support member 860 may be formed of a flexible material such as rubber and silicone to enable elastic deformation. Accordingly, the second support member 860 may offset the pressing force generated in the process of fastening the second substrate 500 to the connector 400 due to its elastic restoring force.

According to the present disclosure, in a battery pack, since a connector is directly mounted on a first substrate, and a second substrate is detachably coupled to the connector, it is possible to flexibly respond to positional changes between a battery cell and an external substrate, and costs for producing the battery pack can be reduced.

According to the present disclosure, in a battery pack, since a length of a first region of the second substrate is formed larger than a length of a second region thereof, the size of a region in which the second substrate interferes with the external substrate can be relatively reduced, and a wider space can be secured for mounting components on the external substrate.

According to the present disclosure, by a support member, it is possible to prevent the first substrate from being deformed and sagging due to a pressing force generated in a process of fastening the second substrate to the connector.

According to the present disclosure, the first substrate can be protected from fires, foreign matter, and the like by a protective film, and the time taken for a process of installing the protective film can be reduced by a marking line.

However, the effects obtainable through the present disclosure are not limited to the above effects, and other technical effects that are not mentioned will be clearly understood by those skilled in the art from the following description of the present disclosure.

While the present disclosure has been described with reference to embodiments shown in the drawings, these embodiments are merely illustrative and it should be understood that various modifications and equivalent other embodiments can be derived by those skilled in the art on the basis of the embodiments.

Therefore, the technical scope of the present disclosure is defined by the appended claims and equivalents thereof.

## Claims

1. A battery pack comprising:
a battery cell (100);
a terrace (200) extending from the battery cell (100);
a first substrate (300) disposed on the terrace (200) and connected to the battery cell (100);
a connector (400) mounted on the first substrate (300); and
a second substrate (500) detachably coupled to the connector (400) and extending to the outside of the battery cell (100).

2. The battery pack as claimed in claim 1, wherein the first substrate (300) comprises:
a first surface (301) disposed to face the terrace (200); and
a second surface (302) disposed at an opposite side of the first surface (301),
wherein the connector (400) is mounted on the second surface (302).

3. The battery pack as claimed in claim 1 or 2, wherein the connector (400) is disposed in a central portion of the first substrate (300).

4. The battery pack as claimed in any one of the preceding claims, further comprising a pair of connection tabs (305) configured to extend from the terrace (200) and to connect the battery cell (100) and the first substrate (300),
wherein the connector (400) is disposed between the pair of connection tabs (305).

5. The battery pack as claimed in any one of the preceding claims, wherein the second substrate (500) has flexibility.

6. The battery pack as claimed in any one of the preceding claims, wherein the second substrate (500) comprises:
a first region (510) disposed to face the battery cell (100); and
a second region (520) configured to extend from the first region (510) and to protrude to the outside of the battery cell (100),
wherein a length of the first region (510) is greater than a length of the second region (520).

7. The battery pack as claimed in any one of the preceding claims, further comprising a support member (800) configured to prevent deformation of the first substrate (300).

8. The battery pack as claimed in claim 7, wherein the support member (800) comprises:
a first support member (810) disposed between the terrace (200) and the first substrate (300); and
a second support member (820) configured to extend from the first support member (810) and to come in contact with a floor surface (F) on which the battery cell (100) is seated.

9. The battery pack as claimed in claim 7, wherein the support member (800) comprises:
a first support member (830) disposed between the terrace (200) and the first substrate (300); and
a second support member (840) spaced apart from the first support member (830) and disposed between the terrace (200) and a floor surface (F) on which the battery cell (100) is seated.

10. The battery pack as claimed in claim 7, wherein the support member (800) comprises:
a first support member (850) fixed to the battery cell (100) and configured to support the first substrate (300) relative to the terrace (200); and
a second support member (860) spaced apart from the first support member (850) and disposed between the terrace (200) and a floor surface (F) on which the battery cell (100) is seated.

11. The battery pack as claimed in claim 10, wherein the first support member (850) comprises:
a support case (851);
an insertion portion (852) disposed in the support case (851) and into which the first substrate (300) is inserted; and
an opening (853) formed to pass through the support case (851) and configured to expose the connector (400) to the outside.

12. The battery pack as claimed in claim 11, wherein the first support member (850) further comprises a separation prevention member (854) configured to protrude from the support case (851) toward the insertion portion (852) and to be elastically deformable.

13. The battery pack as claimed in claim 11 or 12, wherein the first support member (850) further comprises a reinforcing rib (855) coupled to the support case (851) and configured to reinforce the rigidity of the support case (851).

14. The battery pack as claimed in any one of claims 8 to 13, wherein the first support member (810, 830, 850) and/or the second support member (820, 840, 860) are elastically deformable.

15. The battery pack as claimed in any one of the preceding claims, further comprising:
a protective film (600) disposed to surround the first substrate (300) and having a slit (601) through which the connector (400) is exposed to the outside; and
a marking line (700) disposed to be spaced apart from the connector (400) on the first substrate (300) and selectively exposed to the outside according to an area of the slit (601).
